(19) Europäisches Patentamt
European Patent Office
Office européen des brevets

(11) Publication number: **0 050 324**
**B1**

(12) **EUROPEAN PATENT SPECIFICATION**

(45) Date of publication of patent specification: **07.01.87**

(51) Int. Cl.$^4$: **C 01 B 33/02**

(21) Application number: **81108384.9**

(22) Date of filing: **15.10.81**

(54) **Method and apparatus for producing high purity silicon from flames of alkalimetal and silicon halide.**

(30) Priority: **20.10.80 US 199100**

(43) Date of publication of application:
**28.04.82 Bulletin 82/17**

(45) Publication of the grant of the patent:
**07.01.87 Bulletin 87/02**

(84) Designated Contracting States:
**BE DE FR GB IT NL**

(56) References cited:
**US-A-2 912 311**
**US-A-3 041 145**
**US-A-4 102 765**
**US-A-4 102 767**
**US-A-4 150 248**
**US-A-4 188 368**

(73) Proprietor: **AeroChem Research Laboratories, Inc.**
**Box 12**
**Princeton New Jersey 08540 (US)**

(72) Inventor: **Gould, Robert K.**
**37 Hawthorne Lane**
**E. Windsor, N.J. 08520 (US)**
Inventor: **Dickson, Charles R.**
**3C Meadow Lane Apts.**
**Princeton, N.J. 08540 (US)**

(74) Representative: **Dost, Wolfgang, Dr.rer.nat., Dipl.-Chem. et al**
**Patent- und Rechtsanwälte Bardehle-Pagenberg-Dost-Altenburg & Partner Postfach 86 06 20**
**D-8000 München 86 (DE)**

**EP 0 050 324 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a process and apparatus for producing high purity silicon by reacting in vaporized state alkali metal and silicon halide.

A variety of attempts have been made recently to produce inexpensive yet high quality semiconductor and photovoltaic silicon for commercial purposes. The Hemlock process starts with $SiH_2Cl_2$ to produce a semiconductor grade silicon in rod form. The Battelle Memorial Institute process employs silicon tetrachloride and zinc in a fluidized bed to produce solar grade silicon in pellet form. The Union Carbide Corporation has a process involving the decomposition of $SiH_4$ to produce semiconductor silicon in powdered form. The foregoing processes all suffer from at least one of the following problems:

Firstly, the end product silicon is relatively expensive; or, secondly, the effectiveness of the process has not been demonstrated; or, thirdly, there remains a high level of unacceptable impurities in the final silicon products.

The preparation of mono and poly crystalline silicon by techniques involving the reaction of silicon tetrachloride with a metal reductant such as sodium are known in the art. Thus, for example, US—A—4 102 767 discloses the preparation of single crystals of silicon from a poly crystalline sheet or mass formed from the reaction of silicon tetrachloride and sodium in an arc furnace.

US—A—4 102 765 similarly discloses the preparation of high purity silicon by tangentially projecting a silicon halide and an alkali metal into a reaction chamber after the aforementioned reactants have been injected into an electric arc heater. The projection of the reaction mixtures causes the silicon to separate from the metal halide salt, after which the silicon is deposited on a downwardly extending surface to permit it to flow into an associated receptacle. US—A—4 102 765 relies on centrifugal force for the separation of the salt from the purified silicon.

The above techniques have their drawbacks, as the operating temperatures of over 1800°K tend to cause the reaction apparatus to break down with high frequency. Also, the sodium chloride by-product of the reaction is difficult to separate from the silicon and the silicon is therefore of insufficient purity for contemporary uses such as photovoltaic applications. Moreover, the energy requirements of the arc heaters used to heat large amounts of arc gas and subsequently the reactants are unnecessary. It is likely that none of the earlier experimental work recognized the exothermic nature of the reaction and its significance.

Additionally, the present inventors have developed a process and an apparatus for producing high purity silicon comprising reacting in vaporized state at an ambient pressure of up to about one atmosphere in a reaction zone alkali metal and silicon halide to produce a reaction mixture comprising gaseous alkali metal halide and liquid silicon in a droplet fume mixed with the salt vapor, and exhausting said reaction mixture through the orifice of a nozzle means into a separation zone maintained at an ambient pressure less than one half of said reaction zone so as to form a jet stream travelling at supersonic speed including jet velocities in the subsonic range on the edge of the supersonic range, as well as separating and collecting the liquid silicon from said jet stream in a simple hollow crucible.

The said process and apparatus, respectively, are described in the following publications: "Silicon Halide — Alkali Metal Flames as a Source of Solar Grade Silicon" by D.B. Olson and R.K. Gould, DOE/JPL 954777—79/7; "Development of a Model and Computer Code to Describe Solar Grade Silicon Production Processes" by R. Srivastave and R.K. Gould, DOE/JPL 954 862—6; and Olson, Miller, and Gould, AeroChem TP-395, DOE/JPL 95477—80/8, January 1980, pgs. 49—54.

However, it was found that the aforesaid process and apparatus, respectively, was unable to separate the silicon from the salt vapor to permit silicon of the desired purity to be recovered.

Accordingly, it is a principal object of the present invention to provide a method and apparatus for preparing high purity silicon from the reaction of a silicon halide and an alkali metal, whereby the separation of the silicon product from the resulting alkali salt results in the recovery of a high purity consolidated metallic silicon product. The separation process is also a purification process since impurities such as B and P are simultaneously removed as salts from the Si.

It is a further object of the present invention to provide a method and apparatus as aforesaid which operates with a high throughput and efficiently at a reduced energy expenditure.

It is a yet further object of the present invention to provide a method and apparatus as aforesaid which facilitates the collection of the purified silicon product in a variety of forms, such as pellets, single crystals, sheets and ingots.

Accordingly, the invention relates to a process for producing high purity silicon by reacting in vaporized state at an ambient pressure of up to about one atmosphere in a reaction zone alkali metal and silicon halide to produce a reaction mixture comprising gaseous alkali metal halide and liquid silicon in a droplet fume mixed with the salt vapor, and exhausting said reaction mixture through the orifice of a nozzle means into a separation zone maintained at an ambient pressure less than one half of said reaction zone so as to form a jet stream travelling at supersonic speed including jet velocities in the subsonic range on the edge of the supersonic range, as well as separating and collecting the liquid silicon from said jet stream which process is characterized in that said separation of said liquid silicon from said reaction mixture jet stream is effected by way of a substantially flat separator plate heated to a temperature in the range from 1412 to 1500°C and located in the path of said jet stream

so as to create a shock zone upstream of said separator plate causing the gaseous products to be carried away whereas the silicon droplets are impinged on said separator plate to obtain separate liquid silicon suitable for collection.

Furthermore, the invention relates to an apparatus for producing high purity silicon from flames of an alkali metal and silicon halide comprising reactor means (12) for reacting the alkali metal and silicon halide to produce a reaction mixture comprising gaseous salt and liquid silicon in a droplet fume mixed with the salt vapor, a vacuum chamber associates with said reactor means, nozzle means (24) connected to said reactor means and discharging into said vacuum chamber for producing a reaction mixture jet of substantially supersonic velocity, separator means located adjacent said nozzle means and within said vacuum chamber and separated from said nozzle means for interrupting the flow of said reaction mixture jet, and collector means (14, 60) proximately associated with said separator means for collecting the separated liquid silicon which apparatus is characterized by utilizing as said separator means a substantially flat plate (52) with an impact surface spaced above said collector means (60) and located in the path of said reaction mixture jet to create a shock zone upstream of said plate, and with temperature control means for maintaining the temperature of said plate at approximately the melting point of silicon at the pressure within said vacuum chamber.

The process of the invention comprises vaporizing a silicon halide, such as silicon tetrachloride, and an appropriate reducing metal such as sodium, and mixing the two vaporized materials in a reaction chamber to form the reaction products of gaseous sodium chloride and liquid silicon. The reaction may take place at a temperature approximating the melting point of silicon, and, in one embodiment may range from approximately 1412—1600°C. 1412°C is the inventor's best estimate of the initial melting point of Si and is used herein merely to suggest that point. The reaction is performed at pressures which may range up to about one atmosphere (absolute), and preferably ranges from 0.1—0.5 atmospheres. Under these moderate pressures, the silicon liquefies, while the sodium salt remains in the gaseous state. Other impurities form salts such as $BCl_3$ and $PCl_3$ which are separated from the Si. Experiments show that many common impurities such as B and P concentrate in salt rather than Si resulting in a more pure Si than otherwise might be expected.

The liquid silicon is released from the reaction chamber through a small hole, into a separation chamber maintained at a pressure of less than one half that of the reactor, so that the reaction products form a supersonic jet. While a supersonic jet is preferred it may be possible for the process to work in the subsonic range just below the supersonic and therefore the use of the term "supersonic" is meant to comprehend the marginal subsonic range as well. The preferred pressure range of the separation chamber is from 0.001—0.1 atmosphere. The supersonic jet is then caused to impinge upon said substantially flat separator plate whereupon the silicon droplets in the jet deposit and purified liquid silicon is collected. The salt vapor easily separates from the silicon jet, and can be drawn off by the action of an appropriate pumping means, or by the circulation of a sweeper gas medium.

The apparatus of the present invention comprises a reactor having reactant inlet ports for the injection of the gaseous reactants, and electrical heating means for raising and maintaining the temperature of said reactor within the range set forth above. Heat from the preheating means is required only at a start-up phase of the process and not after the process has been initiated. The reactor includes an exit port or nozzle means of a size effective to promote the formation of the supersonic jet of said liquid silicon.

The present apparatus includes a substantially flat plate as separator means which may, in one embodiment, comprise a heated surface against which the supersonic jet of said liquid silicon may impinge. Preferably, the separator means is maintained in an atmosphere having a pressure lower than that of said reactor means — all as set forth with reference to the method above. Separation of the liquid silicon and the vaporized salt occurs by the impaction of the silicon droplets upon the separator means which may, in one embodiment, be maintained at a predetermined distance from said nozzle means related to the orifice size of the latter.

The apparatus of the present invention further includes a collector means for receiving the separated liquid silicon. The collector means may comprise a crucible or dish, or a planar surface or any other vessel of suitable geometry.

The apparatus of the present invention is adapted for operation in either the vertical or horizontal position. In one embodiment, the apparatus may be disposed so that the supersonic jet containing liquid silicon droplets is forced to flow in the horizontal direction against the separator means causing the droplets to condense to the liquid phase. In this embodiment, the separated liquid silicon flows downward, aided by the force of gravity, and is collected in an appropriate collector means, while the salt by-product, in the gaseous form, flows upward and away from the point of impaction on the surface of the separator means and is subsequently condensed.

In a yet further embodiment, the reactor means may define a plurality of nozzle means, in the instance where the reactor is of sufficient size, to facilitate commercial scale production of purified silicon. Alternatively the nozzle means may comprise an elongated slit or a plurality of slots.

The apparatus and method described herein not only permit an expensive high purity silicon to be produced, but also allows for the silicon to be collected in a variety of convenient forms, including pellets, single crystals, sheets and ingots.

In accordance with the present invention a method for preparing purified silicon is disclosed which comprises vaporizing a silicon halide such as silicon tetrachloride, and an appropriate reducing metal such as sodium, and mixing the two vaporous materials in a reaction chamber to form the reaction products of the gaseous alkali metal salt and liquid silicon. However, $SiCl_4$ and Na are believed to be the only economical materials suitable for use in this invention. In one embodiment silicon tetrachloride and sodium are vaporized at about one atmosphere, at temperatures of 60°C and 900°C respectively. The vaporation of the reactants provides an opportunity to prepurify them, and also supplies the enthalpy to keep the reaction temperature well above the dew point of the salt by-product.

The vapors of the reactants are mixed in the reactor means or reaction chamber which operates at a wall temperature ranging from about 1412°C to 1600°C, and an ambient pressure of from about 0.1 to about 0.5 atmospheres. In a particular embodiment, the reactor may be operated at a temperature of 1500°C and a pressure of 0.25 atmospheres.

The reaction that occurs between the silicon halide and the alkali metal is extremely rapid and exothermic. For example, the reaction between silicon tetrachloride and sodium in the vapor state proceeds as follows.

$$4Na + SiCl_4 \rightarrow Si + 4NaCl$$

This reaction exhibits heats of reaction at 298 K and 1800 K which are $\Delta H_{298} = -235$ Kcal-mol$^{-1}$ and $\Delta H_{1800} = -110$ Kcal mol$^{-1}$, respectively. The adiabatic flame temperature, depending on pressure, lies in the range 2200—2500 K, but the intense thermal emission from the silicon droplet fume in actual systems quickly drops the temperature. The preferred operating range of the reactor means facilitates the separation of the reaction products, as the sodium chloride and other impurity chlorides such as $BCl_3$ and $PCl_3$ remain in the vaporized or gaseous state, while the silicon exists as a liquid. Were the reaction to take place in a cool reactor means, sodium chloride would condense, and silicon and sodium chloride would then rapidly freeze so that the resulting product would be a very fine brown powder made up to 90% by weight salt particles and 10% by weight submicron sized silicon particles.

After the reaction products are formed in the reactor means, the liquid silicon in a droplet fume mixed with sodium chloride vapor exhausts from the reactor means through the orifice of a nozzle means discussed in greater detail later on, into a silicon collection region or separation chamber maintained at a pressure less than one half that of the pressure of the reactor means, so that the silicon stream forms a supersonic jet. The supersonic jet of liquid silicon attains a speed approximately $5 \times 10^4$ cm sec$^{-1}$ or greater (Mach number greater than 1.0) and impinges upon a surface, where the silicon droplets are collected by impaction. The reduced pressure of the separation zone compared to the pressure in the reactor contributes to the formation of the supersonic jet, and may, in one embodiment, range in pressure from 0.001 to 0.1 atmosphere. In a preferred embodiment, the ambient pressure in this separation region was 0.02 atmosphere. As will be described in greater detail hereinafter, the supersonic jet of liquid silicon droplets impinge upon a separator means located in spaced apart, adjacent disposition to the nozzle means of the reactor. The jet has, assuming chemical equilibrium, a temperature of about 1177°C, at which temperature, the silicon is frozen, and a velocity of $1.0 \times 10^5$ cm s$^{-1}$ is attained. Just before reaching the separation means, however, the jet passes through a strong shock after which, it approaches equilibrium, about two thirds of the silicon is remelted, and a gas temperature of about 1412°C is attained and a pressure somewhat less than half that of the reactor means prevails. More particularly, the separator means is heated to a surface temperature of from 1412° to 1500°C, and in particular, a temperature range of 1420°C is favorably maintained. The foregoing conditions causes a rapidly growing, partially fused deposit of silicon to develop, fed by the impacting silicon droplets from the jet. In the instance where a collector means or collector surface is maintained apart from the separator means, if the collector surface is maintained at a temperature of about 1412°C, a deposit of liquid silicon continually flows with assistance from gravity or from the jet away from the impaction area on the separation means, and deposits on the collection means. Since the molten silicon product is held at lower pressures and is flushed with chlorine-containing by-product gases which tend to volatize most contaminants, it is believed that further purification occurs here. The sodium chloride, which remains a gas throughout the jet expansion and silicon collection steps is easily diverted from the product, and may in one embodiment, be permitted to condense on the walls of the water-cooled vacuum envelope that surrounds the process vessel.

Hereinafter, the invention is illustrated by way of the drawings.

Figure 1 illustrates a prior art apparatus in which it was attempted — unsuccessfully — to separate the liquid silicon and collect it in a simple hollow crucible.

Figure 2 is a flow diagram of the process according to one embodiment of the invention.

Figure 3 illustrates the basic jet impaction process in which the liquid silicon is separated from the salt vapor and other impurities.

Figure 4 illustrates an embodiment of the invention in which the reactor nozzle is horizontally disposed so that the liquid sodium flows downwardly under the influence of gravity and the vaporized sale and impurities are swept away by a counter-current stream of gas.

Figure 5 illustrates a flat separator plate suitable for use with the embodiment of Figure 4.

Figure 6 illustrates an embodiment of the invention in which multiple nozzles are employed.

Figure 7 illustrates a technique for preparing silicon sheet.

An apparatus 10 representative of an early, however, unsuccessful model made by the inventors is illustrated in Figure 1. Vaporous sodium is led into the reaction chamber of reactor 12 through inlet tube 20. Similarly, vaporous silicon tetrachloride is introduced into the reaction chamber through tube 22. Reactor 22 is constructed from graphite to withstand the high temperatures of operation. Initially, pre-heaters 16 are energized to prevent an initial build-up of products in a cold reactor. The product of the reaction, namely, liquid silicon droplets, and the vaporous salt exit through nozzle 24. The liquid silicon was expected to be collected in crucible 14 and the gaseous salt drawn off and condensed. Insulation 18 is provided to contain the heat of the exothermic reaction.

Though theoretically operable, the apparatus of Figure 1 is unable to separate the silicon from the salt vapor to permit silicon of the desired purity to be recovered. It is believed that the force of the stream of liquid silicon exiting from nozzle 24 becomes dissipated, and that this inhibits the separation and thus collection of pure silicon.

In accordance with the present invention, an apparatus for producing high purity silicon comprises a reactor means having a nozzle means disposed thereon for the outflow of a jet of salt vapor containing liquid silicon, a separator means in the form of a substantially flat plate located near but separated by a distance from said nozzle means to receive the supersonic jet of liquid silicon on its surface, and a separate collector means disposed adjacent to said separator means to receive the liquid silicon after it impacts said separator means.

Silicon is separated from the salt by impaction upon the separator surface, and is forced to flow into a silicon collector by gravity or by the shear force exhibited by salt vapors passing over it.

Experiments with a separator/collector combination of the invention indicate that high separation efficiencies (i.e. ratio of silicon separated and collected to silicon produced in the reactor) in the neighborhood of 80% or more are possible. By contrast, the deep crucible prior art approach illustrated in Figure 1 showed separation efficiencies of less than 50%.

The apparatus of the present invention utilizes the said separator means, maintaining it at a specific distance from the orifice of the nozzle means. Preferably, the separator means may be disposed a distance of less than 10 nozzle means orifice diameters away from the nozzle means, in order to retain the favorable effects of impaction of the supersonic jet of liquid silicon upon the surface of the separator means. For example, the orifice diameter of the nozzle means may range from about 0.3 to about 1.4 centimeters, while the distance between the nozzle means and the separator means may range from about 1.0 to 10.0 centimeters. More particularly, the orifice diameter of the nozzle means may be 0.7 centimeters, and the distance between the nozzle means and the separator means may be 3.5 centimeters. Naturally, the foregoing dimensions are presented for purposes of illustration and not limitation, as a variety of orifice diameters and distances between the nozzle means and the separator means may be chosen within the scope of the present invention.

Figure 3 illustrates the basic features of the exiting jet 120 as it impinges on a silicon target 128. The jet 120 in the pre shock zone 122 includes NaCl and other chloride impurities in the gaseous state and silicon in the crystalline or liquid state. As the jet approaches target 128 it forms a shock wave 124 and passes into post shock zone 126. The silicon in post shock zone 126 is either crystalline or liquid and is carried by its forward momentum onto target 128 where it is deposited. The gaseous NaCl and other chloride impurities are carried away as a gas 130 and subsequently collected or disposed of as a by-product.

As discussed earlier, the separator means may be disposed apart from the collector means or may operate in combination therewith. Likewise, the present apparatus may be constructed for operation in either the vertical or horizontal plane. An apparatus illustrating horizontal operation of the invention is illustrated by the apparatus 50 of Figure 4. Referring now to Figure 4, reactor nozzle 24 is disposed in the horizontal plane so that the supersonic stream of liquid silicon impinges upon a separator means comprising a tilted or vertical plate 52. As shown in Figure 5, plate 52 is flat.

In the operation of the apparatus 50 in the horizontal plane, the supersonic jet of the reaction products separates, as the salt vapor tends to flow upward along the separator surface, while the liquid silicon flows downward under the force of gravity into a silicon collector means, such as collector 60 illustrated in Figure 4.

The employment of an apparatus 50 disposed in the horizontal plane confers certain advantages upon the present invention, specifically:

(1) Sodium which inadvertently condenses in the sodium delivery line will not easily drop into the reactor causing large pressure bursts as the drops evaporate and react;

(2) Small amounts of silicon which collect in the reactor and become impure due to long residence times will not as readily fall or be forced into the collected silicon but can be made to collect in a sump in the reactor 12;

(3) The saslt vapor tends to flow upward along the surface of plate 52. Thus considerably longer times can be made available for the silicon droplets to reach the separator surface than was required in the previous vertical arrangement thereby increasing separator efficiency; and,

(4) Since the silicon flows downwardly as a thin liquid film while the salt vapor flows upwardly away from the silicon, the silicon can be made to

have an additional opportunity for volatile impurities to evaporate from it. This can be achieved by having a small sweeper flow of inert gas 62, such as argon or other inert gases pass over the silicon film below the point at which the jet strikes the separator surface. The inert gas helps to rapidly dilute and sweep away impurity vapors evaporating from the silicon film. Additional advantages can be made of this small sweeper flow if a small amount of chlorine or fluorine is added to it to halogenate and thus make volatile any of the common impurities typically found in silicon (e.g. As, Al, B, P, transition elements).

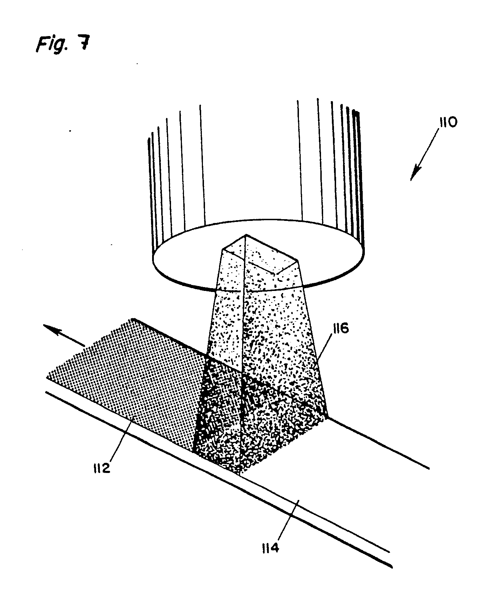

The present apparatus has been described with a reactor means defining a single nozzle means. As noted earlier, in the instance where the nozzle means has an orifice diameter of 0.7 centimeters, silicon flow rates of 0.5 kilogram per hour have been achieved. It has been found that optimal nozzle orifice size contributes to the efficiency of the separation of sodium products. Larger orifices have been found to be undesirable as a way of increasing the rate of production of the silicon product. Thus a further embodiment 70 (Figure 6) of the present invention comprises the provisions of a plurality of nozzle means on a reactor means of sufficient size, so that larger, commercial-scale production of the purified silicon product is possible. Referring now to Figure 6, a plurality of nozzle means 72 are provided which may impinge upon a plurality of correspondingly disposed separator means. In this way, larger quantities of purified silicon per unit time may be produced. Alternatively a greater volume of production can be achieved by using a nozzle or a plurality of nozzles having a slot-like shape. The embodiment of Figure 7 which will be discussed later includes a slot-like orifice having a long and a short dimension.

The apparatus of the present invention can be utilized to prepare silicon in a variety of forms. Thus, the silicon may be prepared in the forms of an ingot, single crystals, a poly crystalline sheet, and the like. In order to produce silicon in ingot form with a vertically disposed apparatus one would allow the silicon after separation to flow or drop under the influence of gravity into a collector in which the silicon liquid would accumulate. The silicon would be allowed to solidify once full. Provision for removing the charged mold and inserting an empty replacement via a gate-valve air lock would allow continuous operation. An efficient embodiment is represented by placing a fixed separator surface above a funnel to provide a non-moving separator target.

Ingot information can also be achieved by use of the apparatus illustrated in Figure 4. According to that embodiment, the downwardly flowing silicon is collected in heated mold 60. The form of the heated mold 60 dictates the exact dimensions of the ingot formed.

A convenient product form for continuous Czochrolski processes is a pellet form of poly crystalline silicon. Pellets can be produced by using a vertical configuration with a funnel-shaped collector. The exit tube from the funnel would preferably have a diameter of 1 mm or less so that droplets with a mass of 0.5 gms or less would drop from the end of the funnel (estimated from surface tension). These droplets would be allowed to solidify either by splat cooling or in a large cooled silicon collector or solidified during their fall through a shot tower.

In the horizontal configuration of Figure 4 the silicon would drop from the low end of the separator plate 52. Droplet size could be minimized by placing fine quartz or graphite fibers at the end of the separator from which the silicon would drip.

The use of flames of sodium and silicon tetrachloride to produce single crystal rods or boules can be done using a vertical configuration apparatus in which the separator itself is a growing single crystal of the silicon. The single crystal is withdrawn as it grows so that the separator surface onto which the silicon is deposited, in this case the top of the growing crystal, is kept a constant distance from the reactor exit orifice. Careful temperature control is needed to maintain the top of the silicon crystal rods at the melting point. That temperature control can be obtained by:

(1) careful control of the reactor wall temperature;

(2) addition of excess silicon tetrachloride to the reactor;

(3) addition of an inert gas, such as argon, to the reactor; and

(4) radiant heating of the rod from electrical heaters placed around the reactor and a crucible utilized as collector. The process is similar in some respects to the Vernueil flame process for producing single crystals of metal oxides such as ruby. The boule sits upon a pedestal which moves downwardly under the influence of a threaded rod. A prime mover, typically a conventional motor, is used to drive the rod. A plurality of salt condensation plates help to take the salt out of the vapor phase to the liquid phase for collection.

A sheet form of silicon product 112 (Figure 7) is desirable for use in fabricating photovoltaic cells. A relatively uncomplicated technique to produce such sheets 112 from a sodium/silicon tetrachloride flame is illustrated as apparatus 110 in Figure 7. According to this embodiment the separator would comprise a moving sheet 114 of a suitable substrate material (e.g. mullite, graphite). A thin layer of silicon 112 would be sprayed upon the substrate sheet 114. The thickness of the silicon sheet 112 is controlled by the rate of speed at which the substrate sheet 114 passes through the jet 116, the rate of silicon production and the separation efficiency.

There are many advantages to the sheet process that are not found in other prior art methods. Specifically, high rates of production are possible through the present process and contamination of the silicon is minimized by the lack of silicon reservoirs and/or dies otherwise normally required. Also the rapid deposition of the silicon

implies that the cooling rates of the deposited silicon can be rapid, thus preventing contamination of the silicon by the substrate material. For this process, rates of sheet formation can be expected to be in the order of meters per hour as opposed to centimeters per hour for other sheet processes.

The embodiment of Figure 7 lends itself to the continuous manufacture of solid state devices such as diodes, transistors and solar cells. Doping of the silicon can be continuously controlled during manufacture.

The preferred embodiment of the invention comprehends introducing Na and $SiCl_4$ into the reactor in the vaporized state. However, it is also within the scope of the invention to introduce the materials into the reactor in a mist form.

The nozzles have been described or illustrated as being circular or slot like. They may also be used individually or in groups as required by the volume demands of the system. It is further likely that other geometric shapes may be satisfactory too and it should be understood that the basic teaching of the present invention is not necessarily limited to any specific shape.

The preferred speed of the jet is in the supersonic range as previously described. However, it is possible that the desired effect may also be achieved with a jet just on the edge of the supersonic range (i.e. in the subsonic range). The term "supersonic" as employed in this disclosure is therefore intended to include subsonic velocities on the edge of the supersonic range that achieve the same results.

It will be appreciated that a major benefit of the present invention is that the separation process is also a purification process that gets rid of impurities such as B and P as chloride salts along with the NaCl.

**Claims**

1. A process for producing high purity silicon by reacting in vaporized state at an ambient pressure of up to about one atmosphere in a reaction zone alkali metal and silicon halide to produce a reaction mixture comprising gaseous alkali metal halide and liquid silicon in a droplet fume mixed with the salt vapor, and exhausting said reaction mixture through the orifice of a nozzle means into a separation zone maintained at an ambient pressure less than one half of said reaction zone so as to form a jet stream travelling at supersonic speed including jet velocities in the subsonic range on the edge of the supersonic range, as well as separating and collecting the liquid silicon from said jet stream, characterized in that said separation of said liquid silicon from said reaction mixture jet stream is effected by way of a substantially flat separator plate heated to a temperature in the range from 1412 to 1500°C and located in the path of said jet stream so as to create a shock zone upstream of said separator plate causing the gaseous products to be carried away whereas the silicon droplets are impinged on said separator plate to obtain separated liquid silicon suitable for collection.

2. The process of claim 1, characterized in that said alkali metal is sodium and said silicon halide is silicon tetrachloride.

3. The process of claim 1 or 2 characterized in that said reacting zone is maintained at a pressure ranging from 0.1 to 0.5 atmospheres, and said separation zone is maintained at a pressure ranging from 0.001 to 0.1 atmospheres.

4. The process of any of claims 1 to 3 characterized in that said reaction is conducted at a temperature ranging from 1412 to 1600°C.

5. The method of any of claims 1 to 4 characterized in that subsequent to said impingement and as the silicon liquid flows with gravity to a collector said liquid is exposed to a counterflow over its surface of a volatizing agent to react with and remove elementary impurities in said liquid silicon.

6. The process of claim 5 characterized in that said volatizing agent is a halogen gas, preferably chlorine or fluorine.

7. An apparatus for producing high purity silicon from flames of an alkali metal and silicon halide comprising reactor means (12) for reacting the alkali metal and silicon halide to produce a reaction mixture comprising gaseous salt and liquid silicon in a droplet fume mixed with the salt vapor, a vacuum chamber associated with said reactor means, nozzle means (24) connected to said reactor means and discharging into said vacuum chamber for producing a reaction mixture jet of substantially supersonic velocity, separator means located adjacent said nozzle means and within said vacuum chamber and separated from said nozzle means for interrupting the flow of said reaction mixture jet, and collector means (14, 60) proximately associated with said separator means for collecting the separated liquid silicon, characterized by utilizing as said separator means a substantially flat plate (52) with an impact surface spaced above said collector means (60) and located in the path of said reaction mixture jet to create a shock zone upstream of said plate, and with temperature control means for maintaining the temperature of said plate at approximately the melting point of silicon at the pressure within said vacuum chamber.

8. The apparatus of claim 7 characterized in that said nozzle means (24) is located substantially horizontally with respect to gravity.

9. The apparatus of claim 7 characterized in that said flat plate is a tilted flat plate (52).

10. The apparatus of claim 7 characterized in that said flat plate comprises a moving substrate (114) upon which said jet (116) impinges so that said silicon is deposited on said substrate as a continuous moving film (112).

11. The apparatus of claim 7 characterized in that said nozzle means comprises a plurality of nozzles (72).

12. The apparatus of claim 7 characterized in that said nozzle means (24) comprises at least one slot-like nozzle.

## Patentansprüche

1. Verfahren zur Herstellung von hochreinem Silicium, bei dem man in einer Reaktionszone bei einem Umgebungsdruck von bis zu etwa einer Atmosphäre im verdampften Zustand Alkalimetall und Siliciumhalogenid zur Bildung eines Reaktionsgemisches umsetzt, das gasförmiges Alkalimetallhalogenid und flüssiges Silicium in einem mit dem Salzdampf gemischten Tröpfchendampf enthält, und bei dem man das Reaktionsgemisch durch die Mündung einer Düseneinrichtung in eine Trennungszone austrägt, die auf einem Umgebungsdruck von weniger als der Hälfte der Reaktionszone gehalten wird, so daß sich ein Strahlstrom bildet, der mit Überschallgeschwindigkeit, unter Einschluß von Strahlgeschwindigkeiten im Unterschallbereich an der Überschallkante, strömt, und bei dem man das flüssige Silicium aus dem Strahlstrom abtrennt und sammelt, dadurch gekennzeichnet, daß die Abtrennung des flüssigen Siliciums aus dem Strahlstrom des Reaktionsgemisches mit Hilfe einer im wesentlichen flachen Trennungsplatte bewirkt wird, die auf einer Temperatur im Bereich von 1412 bis 1500°C aufgeheizt wird, und in der Bahn des Strahlstroms angeordnet ist, so daß strömungsaufwärts der Trennungsplatte eine Stoßzone gebildet wird, die ein Wegtragen der gasförmigen Produkte bewirkt, wogegen die Siliciumtröpfchen auf die Trennungsplatte aufprallen, wobei man zum Sammeln geeignetes, abgetrenntes flüssiges Silicium erhält.

2. Verfahren nach Anspruch 1, dadurch gekennzeichnet, daß das Alkalimetall Natrium und das Siliciumhalogenid Siliciumtetrachlorid ist.

3. Verfahren nach Anspruch 1 oder 2, dadurch gekennzeichnet, daß die Reaktionszone auf einem Druck im Bereich von 0,1 bis 0,5 Atmosphären gehalten wird und daß die Trennungszone auf einem Druck von 0,001 bis 0,1 Atmosphären gehalten wird.

4. Verfahren nach einem der Ansprüche 1 bis 3, dadurch gekennzeichnet, daß die Reaktion bei einer Temperatur im Bereich von 1412 bis 1600°C durchgeführt wird.

5. Verfahren nach einem der Ansprüche 1 bis 4, dadurch gekennzeichnet, daß im Anschluß an das Aufprallen und beim Abfließen der Siliciumflüssigkeit unter Schwerkraft zu einem Sammler die Flüssigkeit mit ihrer Oberfläche einem Gegenstrom eines Verflüchtigungsmittels ausgesetzt wird, das mit elementaren Verunreinigungen im flüssigen Silicium reagiert und diese entfernt.

6. Verfahren nach Anspruch 5, dadurch gekennzeichnet, daß das Verflüchtigungsmittel ein Halogengas, bevorzugt Chlor oder Fluor ist.

7. Vorrichtung zur Herstellung von hochreinem Silicium aus Flammen aus einem Alkalimetall und Siliciumhalogenid, mit Reaktorseinrichtungen (12) zum Umsetzen des Alkalimetalls und des Siliciumhalogenids zur Bildung eines Reaktionsgemisches, das gasförmiges Salz und flüssiges Silicium in einem mit dem Salzdampf gemischten Tröpfchendampf enthält, einer mit den Reaktoreinrichtungen verbundenen Vakuumkammer, mit den Reaktoreinrichtungen verbundenen und in die Vakuumkammer austragenden Düseneinrichtungen (24) zur Bildung eines Strahls des Reaktionsgemisches mit im wesentlichen Überschallgeschwindigkeit, an die Düseneinrichtungen angrenzenden und von den Düseneinrichtungen getrennten Trenneinrichtungen innerhalb der Vakuumkammer zum Unterbrechen der Strömung des Strahls des Reaktionsgemisches, und unmittelbar mit den Trenneinrichtungen verbundenen Sammeleinrichtungen (14, 60) zum Sammeln des abgetrennten flüssigen Siliciums, gekennzeichnet durch die Verwendung einer im wesentlichen flachen Platte (52) als Trenneinrichtung, mit einer oberhalb der Sammeleinrichtungen (60) in einem Abstand angeordneten und in der Bahn des Strahls des Reaktionsgemisches angebrachten Aufprallfläche zur Erzeugung einer Stoßzone strömungsaufwärts der Platte, und mit Temperaturregeleinrichtungen zum Aufrechterhalten der Temperatur der Platte bei etwa dem Schmelzpunkt von Silicium beim Druck innerhalb der Vakuumkammer.

8. Vorrichtung nach Anspruch 7, dadurch gekennzeichnet, daß die Düseneinrichtungen (24) im wesentlichen waagerecht zur Schwerkraft angeordnet sind.

9. Vorrichtung nach Anspruch 7, dadurch gekennzeichnet, daß die flache Platte eine schrägstehende flache Platte (52) ist.

10. Vorrichtung nach Anspruch 7, dadurch gekennzeichnet, daß die flache Platte ein sich bewegendes Substrat (114) einschließt, auf das der Strahl (116) aufprallt, so daß das Silicium auf dem Substrat als ein sich bewegender kontinuierlicher Film (112) abgeschieden wird.

11. Vorrichtung nach Anspruch 7, dadurch gekennzeichnet, daß die Düseneinrichtungen eine Vielzahl von Düsen (72) enthalten.

12. Vorrichtung nach Anspruch 7, dadurch gekennzeichnet, daß die Düseneinrichtungen (24) zumindest eine schlitzartige Düse aufweisen.

## Revendications

1. Procédé pour la revendication de silicium de haute pureté par réaction à l'état vaporisé à une pression ambiante allant jusqu'à environ 1 atmosphère dans une zone de réaction d'un métal alcalin et d'un halogénure de silicium pour produire un mélange de réaction comprenant un halogénure de métal alcalin gazeux et du silicium liquide dans une fumée de gouttelettes mélangées à la vapeur du sel et évacuation dudit mélange réactionnel à travers l'orifice d'une buse dans une zone de séparation maintenue à une pression ambiante inférieure à la moitié de celle de ladite zone de réaction de façon à former un écoulement en jet voyageant à une vitesse supersonique comprenant des vitesses de jet dans la gamme subsonique sur le bord de la gamme supersonique, ainsi que séparation et récupération du silicium liquide à partir de cet écoulement en jet, caractérisé en ce que la séparation

dudit silicium liquide à partir de l'écoulement en jet de mélange réactionnel est effectué au moyen d'une plaque de séparation pratiquement plate, chauffée à une température dans la gamme de 1412 à 1500°C et située sur le trajectoire de cet écoulement en jet de façon à créer une zone de choc en amont de cette plaque de séparation provoquant l'entraînement des produits gazeux tandis que les gouttelettes de silicium entre en collision avec la plaque de séparation pour fournir du silicium liquide séparé pouvant être récupéré.

2. Procédé suivant la revendication 1, caractérisé en ce que ledit métal alcalin est du sodium et en ce que ledit halogénure de silicium est du tétrachlorure de silicium.

3. Procédé suivant la revendication 1 ou 2, caractérisé en ce que ladite zone de réaction est maintenue à une pression dans la gamme de 0,1 à 0,5 atmosphère et que ladite zone de séparation est maintenue à une pression dans la gamme de 0,001 à 0,1 atmosphère.

4. Procédé suivant l'une quelconque des revendications 1 à 3, caractérisé en ce que ladite réaction est conduite à une température dans la gamme de 1412 à 1600°C.

5. Procédé suivant l'une quelconque des revendications 1 à 4, caractérisé en ce qu'après ledit choc et, alors que le silicium liquide s'écoule par gravité dans un collecteur, la surface dudit liquide est exposé à un agent volatilisant qui s'écoule à contre-courant pour réagir avec celui-ci et éliminer les impuretés élémentaires dans ledit silicium liquide.

6. Procédé suivant la revendication 5, caractérisé en ce que ledit agent volatilisant est un halogène gazeux, de préférence le chlore ou le fluor.

7. Appareil pour produire un silicium de haute pureté à partir des flammes d'un métal alcalin et d'un halogénure de silicium comprenant un réacteur (12) pour faire réagir le métal alcalin et l'halogénure de silicium et produire un mélange réactionnel comprenant un sel gazeux et du silicium liquide dans une fumée de gouttelettes mélangées à la vapeur de sel, une chambre à vide associée audit réacteur, une buse (24) reliée audit réacteur et débouchant dans la chambre à vide pour produire un jet de mélange réactionnel de vitesse pratiquement supersonique, un moyen de séparation situé au voisinage de ladite buse et dans ladite chambre à vide, et séparé de la buse pour interrompre l'écoulement dudit jet de mélange réactionnel, et des moyens collecteurs (14, 60) immédiatement associés audit moyen de séparation pour collecter le silicium liquide séparé, caractérisé en ce que le moyen de séparation utilisé est une plaque pratiquement plate (52) avec une surface de choc disposée à une certaine distance au-dessus du moyen collecteur (60) et située sur la trajectoire dudit jet de mélange réactionnel pour former une zone de choc en amont de ladite plaque, et avec un moyen de contrôle de la température pour maintenir la température de ladite plaque au voisinage du point du fusion du silicium à la pression dans ladite chambre à vide.

8. Appareil suivant la revendication 7, caractérisé en ce que la buse (24) est placée pratiquement horizontalement par rapport à la pesanteur.

9. Appareil suivant la revendication 7, caractérisé en ce que la plaque plate est une plaque plate inclinée (52).

10. Appareil suivant la revendication 7, caractérisé en ce que ladite plaque plate comprend un substrat mobile (114) sur lequel ledit jet (116) entre en collision de façon telle que ledit silicium se dépose sur ledit substrat sous forme d'un film mobile continu (112).

11. Appareil suivant la revendication 7, caractérisé en ce que ladite buse comprend une pluralité de buses (72).

12. Appareil suivant la revendication 7, caractérisé en ce que ladite buse (24) comprend au moins une buse en forme de fente.

*Fig. 1.*

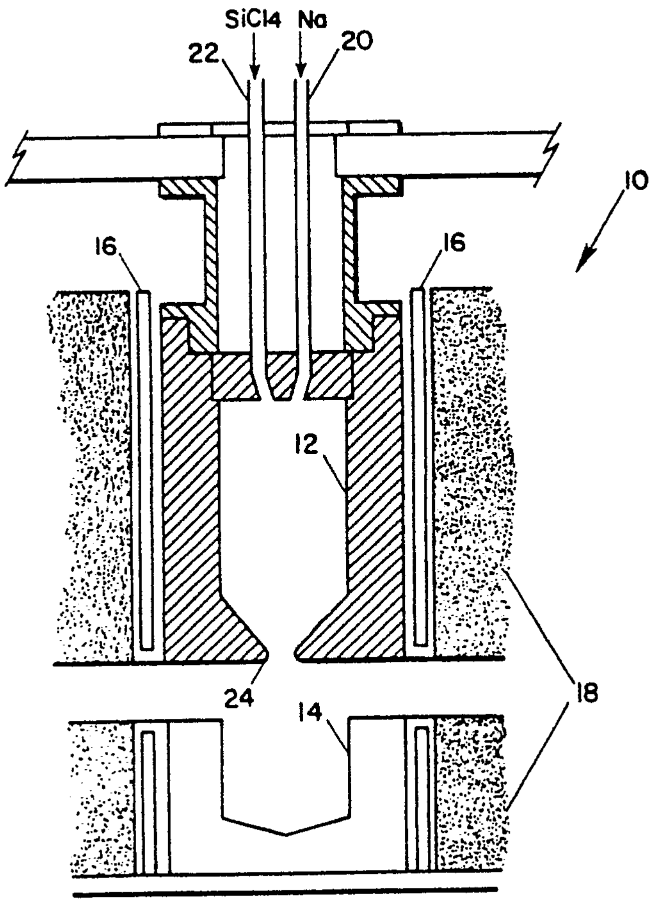

*Fig. 2*

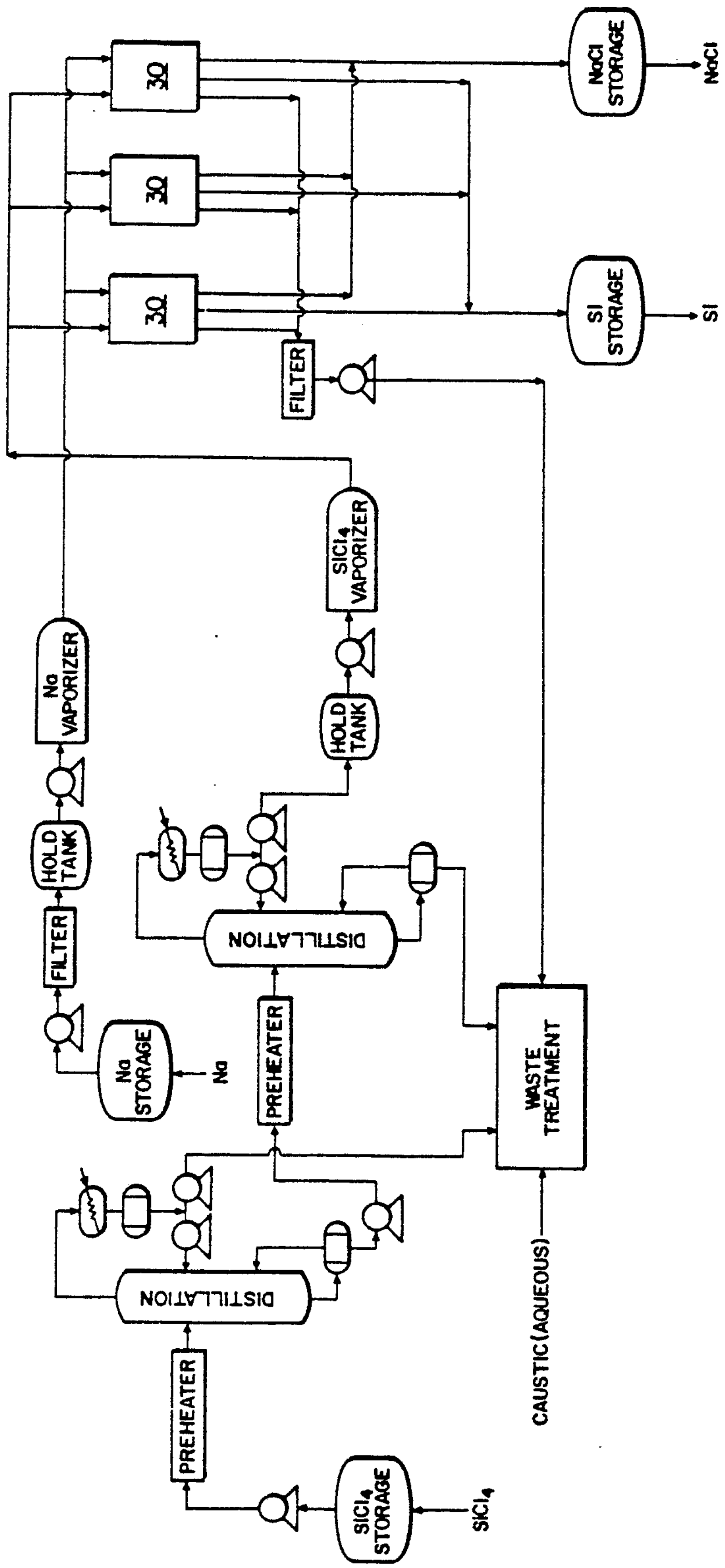

SiCl$_4$ STORAGE
SiCl$_4$
PREHEATER
DISTILLATION
PREHEATER
DISTILLATION
CAUSTIC (AQUEOUS)
WASTE TREATMENT
Na STORAGE
Na
FILTER
HOLD TANK
Na VAPORIZER
HOLD TANK
SiCl$_4$ VAPORIZER
FILTER
30
30
30
Si STORAGE
Si
NaCl STORAGE
NaCl

Fig. 3

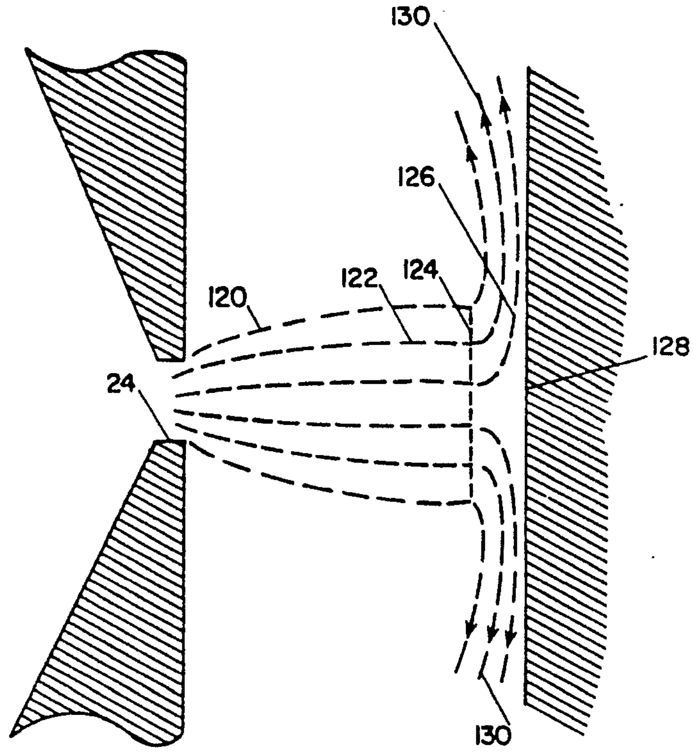


Fig. 5

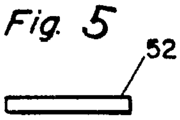


Fig. 4

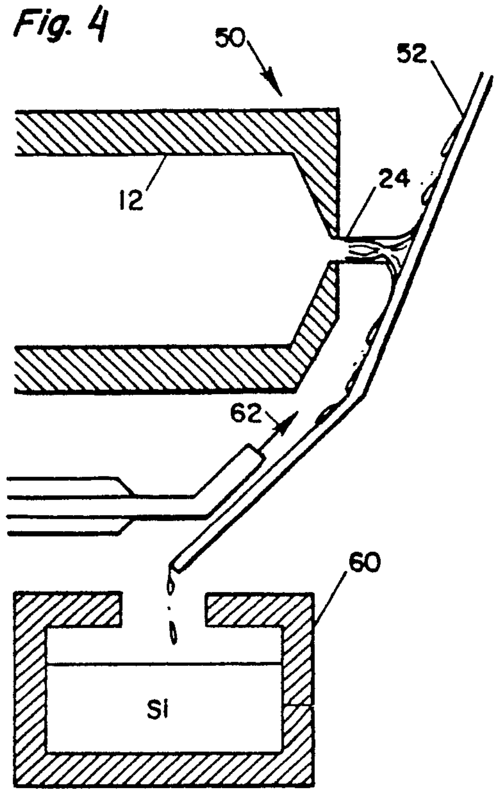

*Fig. 6*

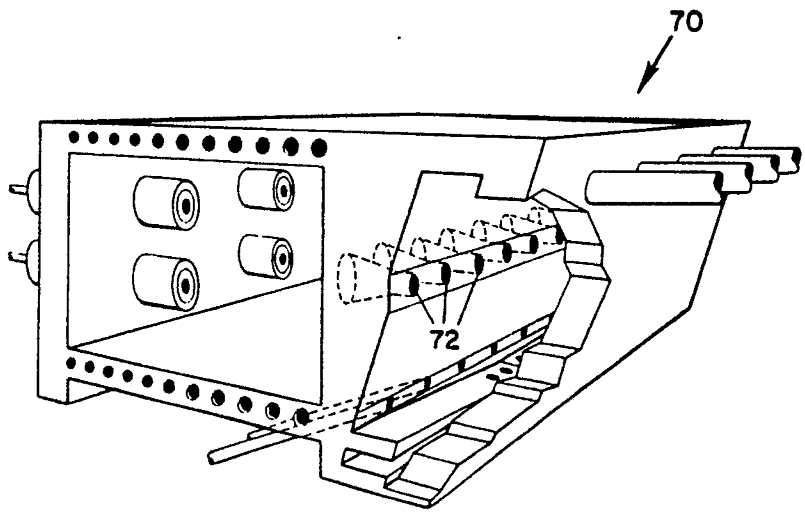

Fig. 7